**Europäisches Patentamt**

**European Patent Office**

**Office européen des brevets**

(19)

(11) Veröffentlichungsnummer : **0 382 831 B1**

(12)

# EUROPÄISCHE PATENTSCHRIFT

(45) Veröffentlichungstag der Patentschrift :
**03.02.93 Patentblatt 93/05**

(51) Int. Cl.$^5$ : **G01N 27/00**

(21) Anmeldenummer : **89908966.8**

(22) Anmeldetag : **09.08.89**

(86) Internationale Anmeldenummer :
**PCT/DE89/00525**

(87) Internationale Veröffentlichungsnummer :
**WO 90/01694 22.02.90 Gazette 90/05**

(54) **CHEMOSENSITIVER WANDLER.**

(30) Priorität : **11.08.88 DE 3827314**

(43) Veröffentlichungstag der Anmeldung :
**22.08.90 Patentblatt 90/34**

(45) Bekanntmachung des Hinweises auf die
Patenterteilung :
**03.02.93 Patentblatt 93/05**

(84) Benannte Vertragsstaaten :
**AT BE CH DE FR GB IT LI LU NL SE**

(56) Entgegenhaltungen :
**EP-A- 0 012 035**
**EP-A- 0 181 206**
**EP-A-01 747 12**
**EP-A-01 932 51**
**DE-A- 3 330 975**
**DE-A- 3 430 941**
**US-A- 4 449 011**
**US-A-45 057 99**

(73) Patentinhaber : **HAMPP, Norbert**
**Ungererstrasse 43**
**W-8000 München 40 (DE)**
Patentinhaber : **BRÄUCHLE, Christoph**
**Rotkäppchenstrasse 89A**
**W-8000 München 83 (DE)**

(72) Erfinder : **HAMPP, Norbert**
**Ungererstrasse 43**
**W-8000 München 40 (DE)**
Erfinder : **BRÄUCHLE, Christoph**
**Rotkäppchenstrasse 89A**
**W-8000 München 83 (DE)**

(74) Vertreter : **Kirchner, Dietrich, Dr.**
**c/o BAYER AG Konzernverwaltung RP**
**Patentabteilung**
**W-5090 Leverkusen, Bayerwerk (DE)**

**EP 0 382 831 B1**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue Saint-Denis, 75001 PARIS

## Beschreibung

### Technisches Gebiet

Die Erfindung betrifft einen chemosensitiven Wandler zur selektiven Bestimmung einer chemischen Eigenschaft eines Fluids, mit wenigstens einem Feldeffekttransistor, dessen Gate mit einer zugeordneten Meßelektrode verbunden ist, die mit einer für die chemische Eigenschaft sensitiven Membran bedeckt ist, und mit einer Kapselung, die den gesamten Wandler mit Ausnahme der Membran gegenüber dem Fluid isoliert.

Unter "chemosensitiv" wird drei eine ionen- oder gassensitive Eigenschaft, eine Empfindlichkeit für Enzymsubstrate, für Antikörper/Antigene oder für hydridfähige DNA/RNA-Gruppen verstanden. Je nach ihrer Sensitivität sind derartige Wandler in der Medizin, etwa zur Blutanalyse, in der klinischen Chemie, zur Therapiesteuerung, Hormonbestimmung, Infektions- und Tumordiagnostik, ferner auch in der Fermentationssteuerung, Lebensmittelanalyse, und Umweltanalytlk sowie für Prozeßsteuerungen einsetzbar.

### Stand der Technik

Ein chemosensitiver Wandler mit den im Oberbegriff des Patentanspruchs 1 angegebenen Merkmalen ist aus EP-B-0 065 350 bekannt. Dort ist in einem Halbleitersubstrat ein Feldeffekttransistor ausgebildet, dessen Gate über einen seitlich anschließenden Leiter mit einer auf der gleichen Substratseite angeordneten Meßelektrode verbunden ist. Die Meßelektrode ist mit einer für die zu bestehende chemische Eigenschaft sensitiven Membran bzw. Schicht versehen, die durch Elektroplattieren, Sputtern oder Aufdampfen aufgetragen wird. Der Feldeffekttransistor ist gegen das zu untersuchende Fluid durch eine Schutzschicht abgekapselt, die aus einem Epoxiharz oder Silikonkautschuk besteht.

Wird der so aufgebaute Wandler mit seiner sensitiven Membran in das zu untersuchende Fluid eingetaucht, so entsteht aufgrund von Ionenaustauschreaktionen zwischen der elektroaktiven Substanz der Membran und dem Fluid an der Gate-Elektrode des Feldeffekttransistors ein Potential, das dessen Kanalleitfähigkeit beeinflußt. Durch potentiometrische oder amperometrische Messung läßt sich ein entsprechendes Ausgangssignal gewinnen, das zur Konzentration des zu messenden Parameters proportional ist.

Weitere chemosensitive Wandler sind aus der EP-A-0 302 228, der EP-B 0 078 590 oder der US-PS 4 514 276 bekannt.

Die durch die genannte Ionenaustauschreaktion hervorgerufene Spannung liegt zwar im mV-Bereich, die ohm'sche Belastbarkeit der Membran liegt jedoch im pA- bis fA-Bereich. Beim Arbeiten mit derart geringen Ladungsmengen kommt es darauf an, daß jegliche Störeinflüsse, insbesondere solche elektrischer oder thermischer natur, ferngehalten werden, wozu die genannten Druckschriften keine Maßnahmen angeben. Eine weitere Schwierigkeit bei den bekannten Wandlern besteht darin, daß sie zum Nachweis nur solcher chemischer Eigenschaften eingesetzt werden können, für die Membranen sensitiv sind, die sich durch die genannten Verfahren auf die Meßelektrode auftragen lassen.

### Beschreibung der Erfindung

Der Erfindung liegt die Aufgabe zugrunde, einen chemosensistiven Wandler anzugeben, der verglichen mit bekannten chemosensiven Wandlern eine höhere Empfindlichkeit aufweist, und der gleichzeitig gegen elektrische Einflüsse als auch gegen Temperaturschwankungen unempfindlich ist, wobei er auch für solche Eigenschaften sensitiv ausgestalbar sein soll, die sich nur mit wenig stabilen Membransubstanzen nachweisen lassen.

Eine erfindungsgemäße Lösung dieser Aufgabe ist im Patentanspruch 1 angegeben:

Erfindungsgemäß ist eine Trägerplatte vorgesehen, auf deren einer Seite die Meßelektrode und auf deren anderer Seite eine den Feldeffekttransistor enthaltende Verstärkerschaltung angeordnet sind; ferner ist die Meßelektrode mit dem Gate des Feldeffekttransistors über einen die Trägerplatte durchsetzenden Leiter elektrisch verbunden.

Die Anordnung von Meßelektrode und Verstärkerschaltung auf gegenüberliegenden Seiten einer Trägerplatte mit Durchkontaktierung durch die Trägerplatte hindurch ergibt bei geringen Gesamtabmessungen des Wandlers und freier Gestaltungsmöglichkeit hinsichtlich Größe und Anzahl der Meßelektrodenflächen kürzeste Entfernungen zwischen der jeweiligen Meßelektrode und der zugehörigen Verstärkerschaltung mit einem entsprechend hohen Signal/Rausch-Verhältnis. Damit ist der erfindungsgemäße Wandler empfindlicher als herkömmliche Wandler. Darüberhinaus ist durch den erfindungsgemäßen Aufbau eine weitgehend freie Wahl der Ausbildung der Meßelektrode(n) und damit eine Anpassung an die verschiedensten Meßproblemen möglich. Insbesondere können als Membranen sämtliche Membrantypen verwendet werden, wie sie bei herkömmlichen Ionen-selektiven Elektroden Verwendung finden.

Ferner kann auch die Verstärkerschaltung in den unterschiedlichsten Techniken ausgebildet sein, beisplelsweise ist ein Aufbau des Wandlers in Hybridtechnik oder Dünnschichtechnik auch bei kleinen Stückzahlen kostengünstig zu realisieren.

Weiterbildungen der Erfindung sind in den Unteransprüchen angegeben:

Gemäß Anspruch 2 besteht die Trägerplatte aus einem isolierenden Material besteht, das insbesondere $SiO_2$, ein keramisches Material wie $Al_2O_3$, Glas, ein Epoxidharz oder ein Kunststoffmaterial sein kann (Anspruch 3). Damit sorgt die Trägerplatte nicht nur bei geringer Dicke für die notwendige Stabilität, sondern schirmt auch die Verstärkerschaltung(en) zuverlässig gegen Umwelteinflüsse ab. Ein keramisches Material wie $Al_2O_3$-Keramik eignet sich beispielsweise dazu, um das Material der Meßelektrode, Leiterschicht und sonstigen Leiterbahnen in Dickschichttechnologie aufzutragen.

Im Anspruch 4 ist gekennzeichnet, daß zwischen der Verstärkerschaltung und der Trägerplatte eine der Meßelektrode gegenüberliegende Leiterschicht angeordnet ist, dieauf das gleiche Potential wie die Meßelektrode gelegt werden kann. Diese Maßnahme führt zu einer aktiven Abschirmung des hochimpedanten Eingangssignals gegen elektrische Störfelder, wodurch das Signal/Rausch-Verhältnis weiter verbessert, die Empfindlichkeitsgrenze des Wandlers herabgesetzt und seine Ansprechgeschwindigkeit erhöht sowie das Übersprechverhalten bei einem Wandler mit mehreren Kanälen verbessert wird. Die Anordnung nach Anspruch 4 bedeutet weiterhin, daß Eingangskapazitäten praktisch vollständig eliminiert werden.

Gemäß Anspruch 5 ist zur elektrischen Verbindung zwischen der Meßelektrode und dem Feldeffekttransistor eine die Trägerplatte durchsetzende Bohrung vorgesehen, die einen Durchmesser von weniger als 0,1 mm hat, und die zumindest an ihrer Wandung mit leitendem Material beschichtet ist Diese Weiterbildung der Erfindung hat den Vorteil, daß wegen des geringen Bohrungsquerschnitts ruhende oder schwach bewegte Flüssigkeiten infolge ihrer Oberflächenspannung auch dann nicht an die Verstärkerschaltung gelangen können, wenn die Außenseite der Bohrung freiliegen sollte.

Nach Anspruch 6 bestehen die Meßelektrode, der die Trägerplatte durchsetzende Leiter sowie gegebenenfalls die Leiterschicht aus einem chemisch gegen das Fluid inerten Material, so daß es keine Reaktion mit dem zu untersuchenden Fluid eingeht und insbesondere für das das Aufbringen der Membranen praktisch beliebige Hilfsstoffe (Lösungsmittel, Reduktions- und Oxidationsmittel, Radikale für Koppelungen und Polymerisationen) gestattet. Derartige Materialien sind beispielsweise Gold, Platin, Silber, Palladium bzw. Legierungen hiervon oder ein leitfähiges Polymer, wie z.B. Polypyrrol.

Im Anspruch 8 ist gekennzeichnet, daß die Fläche der Meßelektrode durch eine auf die Trägerplatte aufgebrachte Maskenplatte begrenzt sein kann. Diese Weiterbildung der Erfindung hat den Vorteil, daß zum Auftragen der Membran auf die Meßelektrode eine trogartige Aufnahme mit definierter Grundfläche gebildet wird, so daß die Membran eine entsprechende Ausdehnung aufweist und in ihrer Dicke durch einfache Flüssigkeitsdosierung festgelegt werden kann. Damit wird auch die Möglichkeit eröffnet, daß der Anwender selbst die Membran mit hinreichender Genauigkeit auftragen kann, was dann erforderlich ist, wenn empfindliche und wenig stabile biologische Materialien wie Enzyme und Antikörper als Membrane verwendet werden sollen. Ferner wird es möglich, verbrauchte Membranen zu entfernen und den Wandler durch Aufbringen einer neuen Membran wiederzuverwenden. Mögliche vom Anwender selbst aufzubringende Membranen sind im Anspruch 13 angegeben, gemäß dem die Membran durch (elektro-)chemische Reaktionen oder in gelöster Form aufbringbar ist. Weiterhin ist es gemäß Anspruch 12 auch möglich, die Maskenplatte abnehmbar bzw. austauschbar anzuordnen:

Damit ist es möglich, die Maskenplatte nur zum Aufbringen der Membran am Wandler anzuordnen bzw. die Membranfläche durch Anbringen unterschiedlich ausgestalteter Maskenplatten zu variieren.

Die Maßnahme des Anspruchs 9, gemäß dem die Maskenplatte die Bohrung bedeckt, ist zum weiteren Schutz der in der Kapselung vorgesehenen Verstärkerschaltung zweckmäßig.

Auch die gemäß Anspruch 10 zwischen der Maskenplatte und der Trägerplatte vorgesehene die Bohrung abdeckende Isolator-Schicht dient zur weiteren Abdichtung der Durchkontaktierung. Diese Isolatorschicht kann nach Anspruch 11 bevorzugt aus $SiO_2$, Polyimid, Epoxidharz, Aluminiumoxid oder einem Silikonharz bestehen.

Sind, wie bei der Ausgestaltung nach Anspruch 14 vorgesehen, auch die Maskenplatte und die die Verstärkerschaltung einkapselnde Abdeckung aus dem Material der Trägerplatte hergestellt, so werden mechanische Spannungen, wie sie sonst infolge von Temperaturschwankungen bei unterschiedlichen Wärmeausdehnungskoeffizienten zu Undichtigkeiten führen könnten, vermieden. Insbesondere eine Keramik bildet darüberhinaus einen guten elektrischen Isolator und ist chemisch inert, d.h. sie reagiert nicht mit dem zu untersuchenden Fluid und ist physiologisch indifferent.

Die nach Anspruch 15 vorgesehen Überdruckbefüllung des Wandlergehäuses mit einem Inertgas stellt eine zusätliche Maßnahme zum Schutz der Verstärkerschaltung gegen eindringenden Wasserdampf dar und verhindert eine Oxidation der elektronischen Bauteile, etwa bei Autoklavierungsvorgängen, wie sie mit temperaturstabilen Sensoren durchführbar sind.

Die Ausbildung gemäß Anspruch 16, nach der der Wandler wenigstens ein Differenzsensor-Paar mit einer aktiven Meßelektrode und inaktiven Meßelektrode aufweist, umgeht die Notwendigkeit einer externen Referenzelektrode, die aber bei dem erfindungsgemäßen Wandler jederzeit verwendet werden kann. Die Sensorkanäle bestehen jeweils aus einem Sensorpaar, dessen Potentiale bezüglich eines Referenzlösungskontakts bestimmt und voneinander subtrahiert werden. Eine Elektrodenfläche wird mit der gewünschten Membran, die andere mit der gleichen, jedoch "carrierfreien" Mischung beschichtet. Unter "carrierfrei" versteht man dabei, daß die Membran bzw. Schicht die sensitive Komponente nich aufweist. Durch die Differenzbildung werden Potentrialinstabilitäten des Referenzlösungskontaktes sowie unspezifische Matrixeffekte der Membranen, wie sie beispielsweise durch die Eindiffusion lipophiler Blutfette hervorgerufen werden, eliminiert.

## Kurze Beschreibung der Zeichnung

Ausführungsbeispiele der Erfindung werden nachstehend anhand der Zeichnungen näher erläutert. In den Zeichnungen zeigen

Fig. 1 eine schematische Darstellung eines chemosensitiven Wandlers im Einsatz,

Fig. 2 einen teilweisen Längsschnitt durch den Wandler gemäß Fig. 1,

Fig. 3 eine Draufsicht auf die die Verstärkerschaltung tragende Fläche der in Fig. 2 gezeigten Trägerplatte,

Fig. 4 und 5 Beispiele für eine elektrische Schaltung zur potentiometrischen bzw. amperometrischen Signalerfassung, und

Fig. 6 Kennlinien eines erfindungsgemäßen Wandlers.

## Beschreibung bevorzugter Ausführungsbeispiele

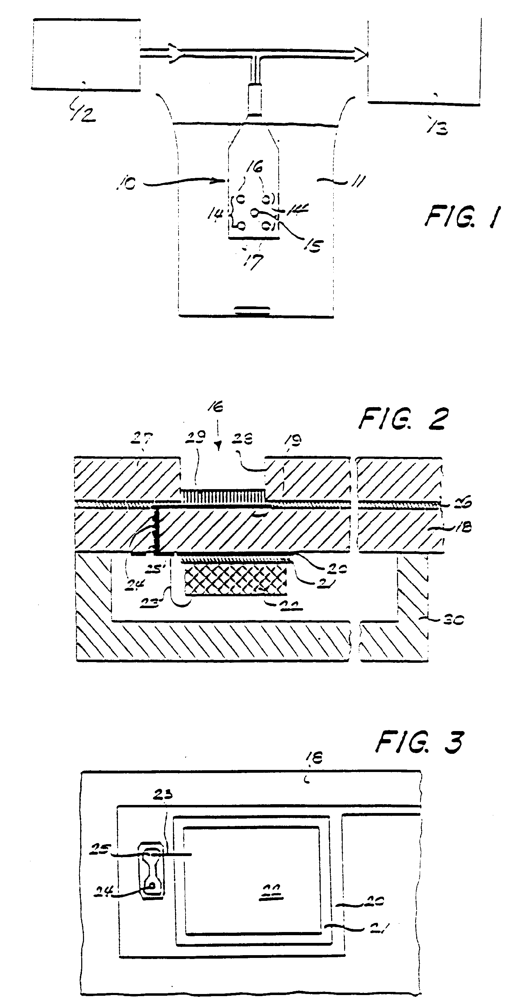

In der in Fig. 1 gezeigten Anordnung taucht ein chemosensitiver Wandler 10 in das zu untersuchende Fluid 11 ein und ist über externe Zuleitungen mit einer Spannungsversorgung 12 und einem Anzeigegerät 13, bei dem es sich bspw. um einen Linienschreiber handeln kann, verbunden.

Der Wandler 10 ist an seiner in Fig. 1 dem Betrachter zugewandten Fläche mit zwei Differenzsensorpaaren 14 und einem Referenzlösungskontakt 15 versehen. Jedes Differenzsensorpaar 14 enthält einen aktiven Sensor 16 und einen passiven Sensor 17. Der aktive und der passive Sensor jedes Differenzsensorpaares 14 sind zu dem Referenzlösungskontakt 15 symmetrisch angeordnet.

In der geschnittenen Teildarstellung der Fig. 2 ist einer der aktiven Sensoren 16 mit zugehöriger Elektronik im einzelnen dargestellt. Der Sensor 16 umfaßt danach eine auf der Oberseite einer aus $Al_2O_3$-Keramik bestehenden Trägerplatte 18 aufgebrachte Meßelektrode 19, der gegenüber auf der Unterseite der Trägerplatte 18 eine Leiterschicht 20 aufgetragen ist.

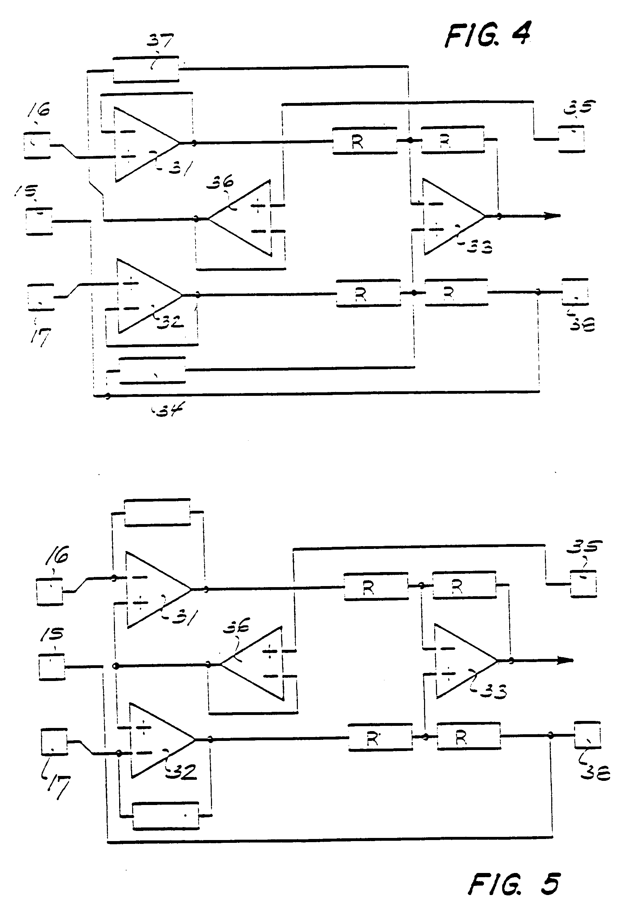

Auf der Leiterschicht 20 ist unter Zwischenschaltung einer $SiO_2$-Isolierschnitt 21 eine Verstärkerschaltung 22 angeordnet, bei der es sich um eine kommerziell erhältliche integrierte Schaltung handeln kann und fair die Beispiele anhand der Fig. 4 und 5 weiter unten kurz erläutert werden.

Das Gate eines Eingangs-Feldeffekttransistors der Verstärkerschaltung 22 ist über einen Draht 23 und einen durchkontaktierenden Verbindungsleiter 24 mit der Meßelektrode 19 verbunden. Der Leiter 24 verläuft durch eine die Trägerplatte 18 durchsetzende, bspw. mittels Laserstrahl hergestellte Mikrobohrung mit einem Durchmesser im Bereich von weniger als 0,1 mm. Zur Herstellung der Meßelektrode 19 und der Leiterschicht 20 wird die Trägerplatte 18 in den betreffenden Flächenbereichen mit Golddruckpaste beschichtet, mit der gleichzeitig die Mikrobohrung aufgefüllt wird. Beim Brennen der Druckpaste bildet sich an der Wandung der Bohrung eine leitende Goldschicht aus.

Fig. 3 zeigt die räumliche Gestaltung der Leiterschicht 20, der darauf aufgebrachten $SiO_2$-Isolierschicht 21 und der auf dieser angebrachten integrierten Verstärkerschaltung 22. In einer Aussparung der Leiterschicht 20 endet der die Mikrobohrung durchsetzende Verbindungsleiter 24 in einem Anschlußlappen 25, an dem der Bonddraht 23 befestigt ist.

Auf der Oberseite der Trägerplatte 18 ist unter Zwischenschaltung einer $SiO_2$-Schicht 26 eine aus $Al_2O_3$-Keramik bestehende Maskenplatte 27 aufgebracht, die im Bereich der Meßelektrode 19 eine Sensoröffnung 28 aufweist. Die von dem Leiter 24 durchsetzte Mikrobohrung befindet sich ausserhalb dieser Sensoröffnung 28 und wird daher von der Maskenplatte 27 abgedeckt und zusätzlich durch die $SiO_2$-Schicht 26 abgedichtet. Im Bereich der Sensoröffnung 28 ist die Meßelektrode 19 mit einer Membran 29 beschichtet, die eine für die nachzuweisende chemische Eingenschaft sensitive Substanz enthält.

Wie aus Fig. 2 hervorgeht, bildet die in der Maskenplatte 27 ausgebildete Sensoröffnung 28 in Verbindung mit der auf der Trägerplatte 18 vorhandenen Meßelektrode 19 eine trogartige Vertiefung mit definierter Grundfläche. Die Membran 29 läßt sich daher sehr einfach in flüssiger Form auftragen, wobei eine vordosierte Flüssigkeitsmenge eine Membran vorgegebener Dicke ergibt. Infolge dieser Gestaltung kann das Aufbringen der Membran 29 dem Anwender überlassen werden und kurz vor dem eigentlichen Einsatz erfolgen, was bei kurzlebigen Substanzen von Bedeutung ist. Ferner eignet sich dieses Auftragsverfahren auch für solche empfindlichen Materialien, die nicht durch herkömmliche Verfahren wie Sputtern oder Aufdampfen aufgebracht werden können. Die Verwendung der keramischen Maskenplatten 27 gestattet es ferner, eine verbrauchte Membran zu entfernen und durch eine neue zu ersetzen, so daß der Wandler insgesamt wiederholt verwendet werden kann.

Ein passiver Sensor 17 unterscheidet sich von dem in Fig. 2 für einen aktiven Sensor 16 beschriebenen Aufbau grundsätzlich nicht. Auch er weist eine Membran auf, die bis auf die sensitive Komponente, die bei der Membran 29 des aktiven Sensors 16 etwa 1% der Membranmasse ausmacht, die gleiche Zusammensetzung hat.

Der in Fig. 1 gezeigte Referenzlösungskontakt 15 weicht dagegen von dem in Fig. 2 gezeigten Aufbau insofern ab, als bei ihm die Meßelektrode ohne Membran freiliegt und keine eigene Beschaltung vorgesehen ist. Der Referenzlösungskontakt 15, der das Bezugspotential für den gesamten Wandler vermittelt, ist in der weiter unten beschriebenen Weise mit der jeweiligen Verstärkerschaltung 22 verbunden.

In dem Aufbau nach Fig. 2 bilden die Meßelektrode 19 und die Leiterschicht 20 mit der dazwischen befindlichen Keramik-Trägerplatte 18 einen Kondensator, der eine geringe Eingangskapazität des Wandlers und eine Abschirmung des hochimpedanten Eingangssignals (im Bereich von $10^{15}\,\Omega$ gegen elektrische Streufelder bewirkt.

In Fig. 2 ist ferner eine Abdeckung 30 dargestellt, die die an der Unterseite der Trägerplatte 18 angebrachte Verstärkerschaltung 22 in Verbindung mit der Trägerplatte 18 umkapselt. Auch die Abdeckung 30 besteht aus $Al_2O_3$-Keramik. Der Rausch innerhalb der Umkapselung ist mit einem inerten Gas unter Überdruck gefüllt, um einem Eindringen von Wasserdampf von außen entgegenzuwirken und Oxidation der elektronischen Komponenten unter Temperatureinfluß zu verhindern. Die Abdeckung 30 kann sich über die gesamte Rückseite des in Fig. 1 dargestellten Wandlers 10 erstrekken und umgibt die Elektronik sämtlicher Sensoren 16, 17.

Dadurch daß der Wandler mit zwei (oder auch mehreren) Differenzsensorpaaren 14 bestückt werden kann, lassen sich bei entsprechender Wahl der selektiven Substanzen der aktiven Sensoren 16 zwei oder mehrere chemische Eigenschaften des Fluids 11 gleichzeitig bestimmen.

In der Schaltung für potentiometrische Signalerfassung nach Fig. 4 ist der aktive Sensor 16 an den Eingangs-Feldeffekttransistor einer ersten Operationsverstärkerstufe 31 und der passive Sensor 17 an den Eingangs-Feldeffekttransistor eines zweiten Operationsverstärkers 32 angeschlossen. Dabei werden zur Impedanzwandlung der Elektrodenpotentiale sehr hochohmige Primärstufen ($R_{in} \approx 10^{15}\Omega$, $I_{in} \approx 150$ fA) eingesetzt. Die niederimpedanten Ausgangssignale der Verstärker 31 und 32 liegen an den beiden Eingängen eines Differenzverstärkers 33, dessen Ausgangssignal des Meßsignal bildet. Der Referenzlösungskontakt 15 ist über einen Widerstand 34 auf den mit dem Signal des passiven Sensors 17 beaufschlagten Eingang des Differenzverstärkers 33 gekoppelt, während ein Trimmeingang 35 über einen weiteren Operationsverstärker 36 und einen weiteren Widerstand 37 auf den mit dem Ausgangssignal des aktiven Sensors 16 beaufschlagten Eingang des Differenzverstärkers 33 gekoppelt ist. Der Referenzlösungskontakt 15 ist ferner mit der Analog-Erdklemme 38 des Wandlers verbunden. Bei potentiometrischen Betrieb wird die Leiterschicht 20 mit dem Ausgang eines der Operationsverstärker 31, 32 verbunden, so daß das impedanzgewandelte Eingangssignal auf die Abschirmfläche gegeben wird.

Die in Fig. 4 mit ihren wesentlichen Bestandteilen dargestellte Schaltung bildet ein Beispiel für die in Fig. 2 mit 22 bezeichnete, in integrierter Form ausgebildete Verstärkerschaltung.

Die Schaltung nach Fig. 5 ist zur amperometrischen Signalerfassung ausgebildet, wobei die gleichen Bezugszeichen wie in Fig. 4 gleiche Schaltungselemente bedeuten. Die unterschiedliche Verdrahtung ergibt sich aus einem Vergleich mit Fig. 4.

Insgesamt weist der vorstehend beschriebene Wandler folgende vorteilhafte Eigenschaften auf:

(a) Im Gegensatz zu herkömmlichen Elektroden gestattet der beschriebene Wandler eine Miniaturisierung des Meßsystems und der Membranoberflächen bei weitgehend vari abler Größe und Formgebung. Der Wandler erfordert nur geringe Herstell- und Entwicklungskosten und läßt sich für die unterschiedlichsten Anwendungsfälle gestalten. Die Sensoren weisen kurze Ansprechzeiten auf. Durch Bestücken mit mehreren Sensoren lassen sich gleichzeitig mehrere Parameter messen. Bei Verwendung von mehreren Membranen mit unterschiedlichen Selektivitäten ist eine weitgehende elektronische Eliminierung der Kreuzselektivitäten einzelner Differenzsensorpaare durch eine nachgeschaltete Elektronik möglich. Die Signalerfassung ist in den Wandler integriert, so daß das Ausgangssignal ohne weitere Aufbereitung zur Anzeige verwendet werden kann.

(b) Gegenüber herkömmlichen chemosensitiven Feldeffekttransistoren weist der oben erläuterte Wandler infolge seiner Einkapselung keine Haltbarkeitsprobleme auf. Die verschiedensten Membransubstanzen lassen sich leicht aufbringen, und es ergibt sich eine höhere Variabilität in der Kombination der bioselektiven Komponenten. Infolge der größeren möglichen Elektrodenoberflächen lassen sich die Mengen der aufzubringenden Membransubstanzen genauer reproduzieren. Diffusionsprobleme, wie sie bei FET-Multisensoren auftreten, werden vermieden.

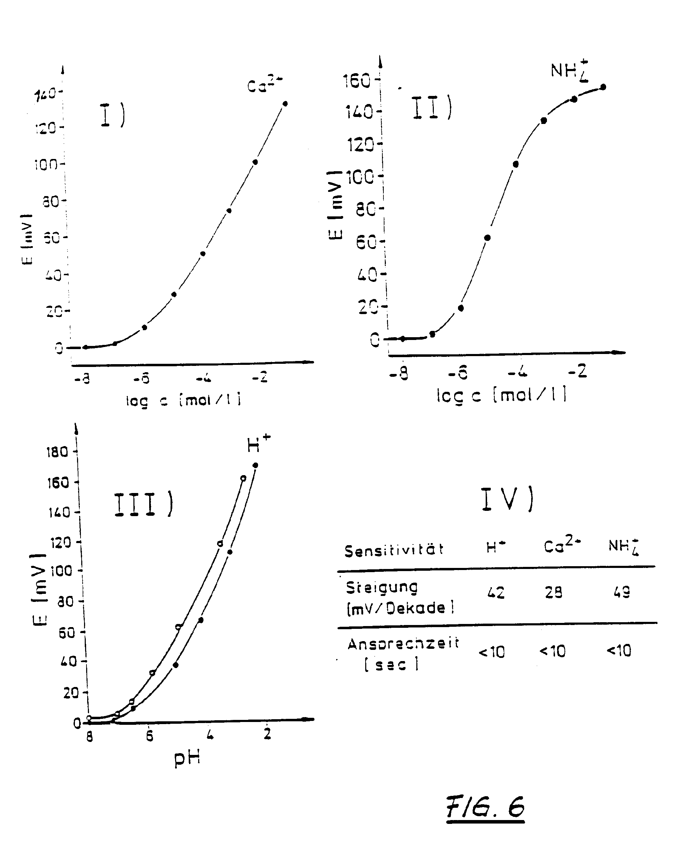

Figur 6 zeigt die Kennlinien eines erfindungsgemäßen Sensors für verschiedene Ionen. Dabei sind ohne Beschränkung des allgemeinen Erfindungsgedankens die Elektrodenflächen mit PVC-Flüssigmembranen sensitiviert. Dafür können aus der Literatur bekante Membranmischungen verwendet werden. Dem Differenzkonzept entsprechend wird für jede Ionenart sowohl eine carrierhaltige als auch eine carrierfreie Membran verwendet.

Zum Aufbringen der Membranen auf die Elektrodenflächen wird wie folgt vorgegangen: Nach dem Trocknen des Sensors über $CaCl_2$ werden 7 µl einer 21 %igen Lösung der PVC-Membranen in THF in die entsprechenden Elektrodenmulden pipettiert. Nach dem Verdampfen des THF wird dieser Vorgang wiederholt. Anschließend erfolgt die Konditionierung der Membranen in einem Elektrolytgemisch.

Durch die Elektrodenmaske ist die Geometrie der Sensorzone exakt definiert, so daß durch einfache Flüssigdosierung reproduzierbar Membranen gleicher Dicke hergestellt werden können. Da die Membranen durch Adhäsion auf der Elektrodenfläche fixiert sind, können sie wieder abgezogen und das Sensormodul nach Reinigung neu beschichtet werden.

In der folgenden Tabelle ist die Zusammensetzung der sensitiven Membranen für die in Figur 6 beispielhaft angegebenen Ionen beschrieben. Die Membranzusammensetzungen entsprechen bei den für klassische Ionen-selektive Elektroden beschriebenen Mischungen. Die Differenzmembranen unterscheiden sich von den sensitiven Membranen durch das Fehlen des Carriers.

| Sensitivität | Carrier | | Matrix | Weichmacher | | Additiv |
|---|---|---|---|---|---|---|
| $Ca^{2+}$ | ETH 1001 | 1% | PVC 66% | oNPOE | 33 % | --- |
| $NH_4^+$ | Nonactin | 1% | PVC 66% | TEHP | 33 % | --- |
| $H^+$ | ETH 1907 | 1% | PVC 66% | oNPOE | 33 % | --- |

```
TEHP  = Tris(2-ethylhexyl)-phosphat
oNPOE = ortho-Nitrophenyloctylether
```

In Figur 6 sind im Teilbild (I) die Ansprechkurven des vorstehend beschriebenen erfindungsgemäßen Sensors für Calcium-Ionen, im Teilbild (II) für Ammonium-Ionen und im Teilbild (III) für Protonen angegeben. Die Ansprechkurven der Teilbilder I und II gelten für wässrige Lösungen der Chloridsalze, das Anspiechverhalten des Protonen-Sensors ist für 500 mM (ausgefüllte Meßpunkte) und für 50 mM (nicht ausgefüllte Meßpunkte) natriumphosphat-Pufferlösung angegenen. Im Teilbild (IV) sind die Ansprechzeiten und die ermittelten Steigungen im linearen Bereich der Sensoren zusammengefaßt.

**Gewerbliche Anwendbarkeit**

Der erfindungsgemäße Sensor kann zu den verschiedensten Messungen im Bereich der Medizintechnik, der chemischen Analysentechnik, des Umweltschutzes etc. eingesetzt werden.

**Patentansprüche**

1.  Chemosensitiver Wandler (10) zur selektiven Bestimmung einer chemischen Eigenschaft eines Fluids (11), mit wenigstens einem Feldeffekttransistor, dessen Gate mit einer zugeordneten Meßelektrode (19) verbunden ist, die mit einer für die chemische Eigenschaft sensitiven Membran (29) bedeckt ist, und mit einer Kapselung (30), die den gesamten Wandler (10) mit Ausnahme der Membran(en) (29) gegenüber dem Fluid (11) isoliert,
    dadurch **gekennzeichnet,** daß eine Trägerplatte (18) vorgesehen ist, auf deren einer Seite die Meßelektrode (19) und auf deren anderer Seite eine den Feldeffekttransistor enthaltende Verstärkerschaltung (22) angeordnet sind, und daß die Meßelektrode (9) mit dem Gate des Feldeffekttransistors über einen die Trägerglatte (18) durchsetzenden Leiter (24) elektrisch verbunden ist.

2. Wandler nach Anspruch 1,
dadurch **gekennzeichnet**, daß die Trägerglatte (18) aus einem isolierenden Material besteht.

3. Wandler nach Anspruch 2,
dadurch **gekennzeichnet**, daß die Trägerplatte aus $Sio_2$, einem keramischen Material wie $Al_2O_3$, Glas, einem Epoxidharz oder einem Kunststoffmaterial besteht.

4. Wandler nach Anspruch 2 oder 3,
dadurch **gekennzeichnet**, daß zwischen der Verstärkerschaltung (22) und der Trägerplatte (18) eine der Meßelektrode (19) gegenüberliegende Leiterschicht (20) angeordnet ist.

5. Wandler nach einem der Ansprüche 1 bis 4,
dadurch **gekennzeichnet**, daß zur elektrischen Verbindung (24) zwischen der Meßelektrode (19) und dem Feldeffekttransistor eine die Trägerplatte (18) durchsetzende Bohrung vorgesehen ist, die einen Durchmesser von weniger als 0,1 mm hat, und die zumindest an ihrer Wandung mit leitendem Material beschichtet ist.

6. Wandler nach einem der Ansprüche 1 bis 5,
dadurch **gekennzeichnet**, daß die Meßelektrode (19), der die Trägerplatte (18) durchsetzende Leiter (24) sowie gegebenenfalls die Leiterschicht (20) aus einem chemisch gegen das Fluid inerten Material bestehen.

7. Wandler nach Anspruch 6,
dadurch **gekennzeichnet**, daß das Material Gold, Platin, Silber, Kupfer, Palladium bzw. Legierungen hiervon oder ein leitfähiges Polymer ist.

8. Wandler nach einem der Ansprüche 1 bis 7,
dadurch **gekennzeichnet**, daß die Fläche der Meßelektrode (19) durch eine auf die Trägerplatte (18) aufgebrachte Maskenplatte begrenzt ist.

9. Wandler nach Anspruch 8 in Verbindung mit Anspruch 5,
dadurch **gekennzeichnet**, daß die Maskenplatte (27) die Bohrung bedeckt.

10. Wandler nach Anspruch 9,
dadurch **gekennzeichnet**, daß zwischen der Maskenplatte (27) und der Trägerplatte (18) eine die Bohrung abdeckende Isolator-Schicht angeordnet ist.

11. Wandler nach Anspruch 10,
dadurch **gekennzeichnet**, daß die Isolator-Schicht aus $SiO_2$, Polyimid, Epoxidharz, Aluminiumoxid oder einem Silikonharz besteht.

12. Wandler nach einem der Ansprüche 1 bis 11,
dadurch **gekennzeichnet**, daß die Maskenplatte (27) abnehmbar ist.

13. Wandler nach einem der Ansprüche 1 bis 12,
dadurch **gekennzeichnet**, daß die Membran (29) durch (elektro-)chemische Reaktionen oder in gelöster Form aufbringbar ist.

14. Wandler nach einem der Ansprüche 1 bis 13,
dadurch **gekennzeichnet,** daß die Trägerplatte (18), die Maskenplatte (27) und eine die Verstärkerschaltung (22) einkapselnde Abdeckung (30) aus dem selben isolierenden Material bestehen.

15. Wandler nach einem der Ansprüche 1 bis 14,
dadurch **gekennzeichnet**, daß der die Verstärkerschaltung (22) umgebende, von der Trägerglatte (18) und einer Abdekkung (30) umschlossene Raum mit Inertgas unter Überdruck gefüllt ist.

16. Wandler nach einem der Ansprüche 1 bis 15,

dadurch **gekennzeichnet**, daß er wenigstens ein Differenzsensor-Paar mit einer aktiven Meßelektrode und einer inaktiven Meßelektrode aufweist.

## Claims

1. Chemically-sensitive transducer (10) for the selective determination of a chemical property of a fluid (11), with at least one field-effect transistor whose gate is connected to an associated measuring electrode (19) that is covered by a membrane (29) sensitive to the chemical property, and with an encapsulation (30) that isolates the entire transducer (10), with the exception of the membrane(s) (29), from the fluid, characterised in that a substrate plate (18) on whose one side the measuring electrode (19) and on whose other side an amplifier circuit (22) containing the field-effect transistor are arranged, is provided, and that the measuring electrode (19) is electrically connected to the gate of the field-effect transistor via a conductor (24) passing through the substrate plate (18).

2. Transducer according to claim 1, characterised in that the substrate plate (18) consists of an insulating material.

3. Transducer according to claim 2, characterised in that the substrate plate consists of $SiO_2$, a ceramic material such as $Al_2O_3$, glass, an epoxy resin or a plastics material.

4. Transducer according to claim 2 or 3, characterised in that a conductive layer (20) is arranged opposite to the measuring electrode (19) between the amplifier circuit (22) and the substrate plate (18).

5. Transducer according to one of the claims 1 to 4, characterised in that a hole which passes through the substrate plate (18), which has a diameter of less than 0.1 mm and whose walls at least are coated with conductive material, is provided for the electrical connection (24) between the measuring electrode (19) and the field-effect transistor.

6. Transducer according to one of the claims 1 to 5, characterised in that the measuring electrode (19), the conductor (24) passing through substrate plate (18) and, if necessary, the conductive layer (20) consist of a material that is chemically inert with respect to the fluid.

7. Transducer according to claim 6, characterised in that the material is gold, platinum, silver, copper, palladium or alloys thereof, or a conductive polymer.

8. Transducer according to one of the claims 1 to 7, characterised in that the area of the measuring electrode (19) is limited by a masking plate placed on the substrate plate (18).

9. Transducer according to claim 8 in conjunction with claim 5, characterised in that the masking plate (27) covers the hole.

10. Transducer according to claim 9, characterised in that an insulating layer covering the hole is arranged between the masking plate (27) and the substrate plate (18).

11. Transducer according to claim 10, characterised in that the insulating layer consists of $SiO_2$, polyamide, epoxy resin, aluminium oxide or a silicone resin.

12. Transducer according to one of the claims 1 to 11, characterised in that the masking plate (27) is removable.

13. Transducer according to one of the claims 1 to 12, characterised in that the membrane (29) can be applied by (electro-) chemical reactions or in a dissolved form.

14. Transducer according to one of the claims 1 to 13, characterised in that the substrate plate (18), the masking plate (27) and a covering (30) encapsulating the amplifier circuit (22) consist of the same insulating material.

15. Transducer according to one of the claims 1 to 14, characterised in that the space enclosing the amplifier circuit (22), that is bounded by the substrate plate (18) and a covering (30), is filled with inert gas under a pressure that is above atmospheric pressure.

16. Transducer according to one of the claims 1 to 15, characterised in that it contains at least one pair of differential sensors with an active measuring electrode and an inactive measuring electrode.

**Revendications**

1. Transducteur chimiosensible (10) pour la détermination sélective d'une propriété chimique d'un fluide (11), avec au moins un transistor à effet de champ dont la grille est reliée à une électrode de mesure correspondante (19) recouverte d'une membrane (29) sensible vis-à-vis de la propriété chimique, et avec un encapsulage (30) isolant par rapport au fluide l'ensemble du transducteur (10) à l'exception de la membrane (29), caractérisé en ce qu'il est prévu une plaque de support (18) portant d'un côté l'électrode de mesure (19) et de l'autre côté un circuit amplificateur (22) comportant un transistor à effet de champ, et en ce que l'électrode de mesure (19) est reliée électriquement avec la grille du transistor à effet de champ par un conducteur (24) traversant la plaque de support (18).

2. Transducteur selon la revendication 1, caractérisé en ce que la plaque de support (18) est composée d'un matériau isolant.

3. Transducteur selon la revendication 2, caractérisé en ce que la plaque de support est composée d'un matériau comme $Al_2O_3$, du verre, une résine époxy ou une matière synthétique.

4. Transducteur selon la revendication 2 ou 3, caractérisé en ce qu'une couche conductrice (20) est prévue entre le circuit amplificateur (22) et la plaque de support (18), du coté opposé à celui de l'électrode de mesure (19).

5. Transducteur selon l'une des revendications 1 à 4, caractérisé en ce qu'il est prévu, pour la connexion électrique (24) entre l'électrode de mesure (19) et le transistor à effet de champ, une forure traversant la plaque de support (18), présentant un diamètre inférieur à 0,1 mm, et revêtue au moins sur sa paroi d'un matériau conducteur.

6. Transducteur selon l'une des revendications 1 à 5, caractérisé en ce que l'électrode de mesure (19), le conducteur (24) traversant la plaque de support (18) ainsi qu'éventuellement la couche conductrice (20) consistent en un matériau chimiquement inerte vis-à-vis du fluide.

7. Transducteur selon la revendication 6, caractérisé en ce que le matériau est de l'or, du platine, de l'argent, du cuivre, du palladium ou leurs alliages, ou un polymère conducteur.

8. Transducteur selon l'une des revendications 1 à 7, caractérisé en ce que les surfaces de l'électrode de mesure (19) sont limitées par une plaque de masquage appliquée sur la plaque de support (18).

9. Transducteur selon la revendication 8 en relation avec la revendication 5, caractérisé en ce que la plaque de masquage (27) couvre la forure.

10. Transducteur selon la revendication 9, caractérisé en ce qu'il est prévu entre la plaque de masquage (27) et la plaque de support (18) une couche d'isolant recouvrant la forure.

11. Transducteur selon la revendication 10, caractérisé en ce que la couche d'isolant est composée de $SiO_2$, de polyimide, de résine époxy, d'oxyde d'aluminium ou d'une résine de silicone.

12. Transducteur selon l'une des revendications 1 à 11, caractérisé en ce que la plaque de masquage (27) est amovible.

13. Transducteur selon l'une des revendications 1 à 12, caractérisé en ce que la membrane (29) peut être appliquée par des réactions (électro-) chimiques ou sous forme dissoute.

14. Transducteur selon l'une des revendications 1 à 13, caractérisé en ce que la plaque de support (18), la plaque de masquage (27) et un recouvrement (30) encapsulant le circuit amplificateur (22) sont composés du même matériau isolant.

**15.** Transducteur selon l'une des revendications 1 à 14, caractérisé en ce que l'espace entourant le circuit amplificateur (22), délimité par la plaque de support (18) et un recouvrement (30) est rempli de gaz inerte sous surpression.

**16.** Transducteur selon l'une des revendications 1 à 15, caractérisé en ce qu'il comporte au moins une paire de capteurs différentiels avec une électrode de mesure active et une électrode de mesure inactive.

FIG. 1

FIG. 2

FIG. 3

FIG. 4

FIG. 5

*FIG. 6*